# EUROPÄISCHE PATENTANMELDUNG

(11) **EP 1 729 139 A2**
(43) Veröffentlichungstag der Anmeldung: **06.12.2006**
(21) Anmeldenummer: 06010296.9
(22) Anmeldetag: 18.05.2006
(51) Int. Cl.: G01R 31/12

(54) **Verfahren und Vorrichtung zur Messung einer dielektrischen Antwort eines elektrischen Isoliersystems**

(30) Priorität: 02.06.2005 DE 102005025449
(71) Anmelder: Omicron electronics GmbH, 6833 Klaus (AT)
(72) Erfinder: Borsi, Hossein, 30519 Hannover (DE); Gockenbach, Ernst, 31303 Burgdorf (DE); Krüger, Michael, 6844 Altach (AT)
(74) Vertreter: Banzer, Hans-Jörg

(57) **Zusammenfassung**

Verfahren und Vorrichtung zur Messung einer dielektrischen Antwort eines elektrischen Isoliersystems, wobei mit einem Frequenzbereichverfahren (2) ein erstes Messergebnis (8) und mit einem Zeitbereichverfahren (3) ein zweites Messergebnis (9) bestimmt wird, woraufhin das erste Messergebnis (8) und das zweite Messergebnis (9) zu einem Gesamtmessergebnis (10) als dielektrische Antwort kombiniert werden. Als Messverfahren für den Frequenzbereich und den Zeitbereich können Standartmessverfahren dienen, beispielsweise das FDS- und PDC-Verfahren.

## Beschreibung

Die vorliegende Erfindung betrifft ein Verfahren und eine Vorrichtung zur Messung einer dielektrischen Antwort eines elektrischen Isoliersystems, wobei aus einem ersten Messergebnis eines Frequenzbereichverfahrens und einem zweiten Messergebnis aus einem Zeitbereichverfahren ein Gesamtmessergebnis als dielektrische Antwort kombiniert wird.

Elektrische Isoliersysteme werden zu Isolationszwecken bei Leistungstransformatoren verwendet, wie sie beispielsweise bei Energieversorgungsunternehmen eingesetzt werden. Solche Transformatoren sind wichtige und kostenintensive Komponenten elektrischer Energieversorgungsnetze und weisen weltweit im Allgemeinen ein hohes Betriebsalter auf. Daher liegt ein großes Interesse der Energieversorgungsunternehmen darin, Maßnahmen zur Lebensdauerverlängerung und Lastoptimierung von Leistungstransformatoren zur Verfügung zu haben. Zu diesem Zweck muss der Zustand der Transformatoren beurteilt werden, was durch verschiedene Diagnoseverfahren vor Ort durchgeführt werden kann. Mit solchen Diagnoseverfahren soll beurteilt werden, inwieweit beispielsweise ein durch elektrische, thermische oder mechanische Beanspruchung hervorgerufenes Gefährdungspotenzial nicht mehr vertretbar ist und Maßnahmen zur Wartung, Instandhaltung oder Erneuerung eingeleitet werden müssen. Neben dem frühzeitigen Erkennen kritischer Anlagenzustände sollen solche Diagnoseverfahren auch dazu geeignet sein, um Wartungsarbeiten an der Anlage erst dann auszuführen, wenn der Zustand dieser es erfordert. Durch den Einsatz von Diagnosesystemen sollen insbesondere eine Verlängerung der Restnutzungsdauer, eine bessere Auslastung, eine höhere Verfügbarkeit und Versorgungssicherheit, eine zustandsorientierte Wartung und Instandsetzung und eine Verhinderung des Ausfalls und der Zerstörung des Transformators erreicht werden.

Als Diagnoseverfahren wird zwischen Online- und Offlineverfahren unterschieden, d.h. Verfahren, welche während des Betriebs oder nur bei Betriebsunterbrechung durchgeführt werden können. Im Einzelnen können die Verfahren noch in chemische, elektrische, dielektrische und weitere nicht elektrische aufgespaltet werden. Die dielektrischen Verfahren zeichnen sich insbesondere dadurch aus, dass sie einen genaueren Blick auf das Isoliersystem und Aussagen über deren Zustand erlauben. Des Weiteren erlauben elektrische/dielektrische Verfahren gegenüber den chemischen Aussagen über den aktuellen Zustand des Leistungstransformators. Daher wird nachfolgend näher auf den Stand der Technik von dielektrischen Verfahren Bezug genommen.

Ein erstes dielektrisches Verfahren stellt das so genannte RVM(Recovery Voltage Measurement)-Verfahren dar. Dieses ist dadurch gekennzeichnet, dass zunächst eine Gleichspannung für eine bestimmte Zeit an die Klemmen des Transformators angelegt wird. Hierdurch werden Polarisationsvorgänge im Dielektrikum in der Weise in Gang gesetzt, dass der Polarisationsstrom nach einem sprunghaften Anstieg hyperbolisch bis zu dem Zeitpunkt abnimmt, an dem die Gleichspannung abgeschaltet wird. Nach diesem damit verbundenen Aufladen des Dielektrikums und dem Abschalten der Gleichspannung werden die Klemmen des Transformators kurzgeschlossen, wodurch ein ebenfalls hyperbolisch abklingender, allerdings umgekehrt gerichteter Depolarisationsstrom hervorgerufen wird. Nach einer bestimmten Zeit wird der Kurzschluss gelöst, und es baut sich eine so genannte Wiederkehrspannung auf, welche sich an den Klemmen des Transformators messen lässt. Diese Wiederkehrspannung wird durch die Relaxationsprozesse im Dielektrikum verursacht. Da die Relaxationsprozesse mit dem Zustand des Isoliermaterials korrelieren, können von dem Verlauf der Wiederkehrspannung Rückschlüsse auf den Zustand des Isoliermaterials gezogen werden, was das Prinzip der RVM-Messung darstellt.

Ein weiteres Verfahren zur Bestimmung des Zustands eines elektrischen Isoliersystems an Leistungstransformatoren ist durch eine so genannte PDC(Polarisation and Depolarisation Current)-Analyse gegeben. Damit kann insbesondere der Alterungszustand sowie die Feuchtigkeit der Isolierung bestimmt werden. Das PDC-Verfahren beruht darauf, dass ein elektrisches Feld an die Isolierung durch eine Gleichspannung an die Klemmen des Transformators erzeugt wird und der dadurch verursachte Polarisationsstrom gemessen wird. Anschließend wird die Gleichspannung entfernt und der Depolarisationsstrom gemessen. Aus dem Polarisationsstrom sowie dem Depolarisationsstrom und unter Berücksichtigung der Kapazität des dielektrischen Materials kann die Antwortfunktion sowie die Leitfähigkeit der Isolierung bestimmt werden.

Als drittes Verfahren zur Messung des Zustands der Isolierung ist ein FDS(Frequency Domain Spectroscopy)-Verfahren gemäß dem Stand der Technik zu nennen. Dieses Verfahren basiert auf der Verallgemeinerung der bekannten tan-δ-Messung bei Netzfrequenz. Im Unterschied zu diesem werden bei der FDS allerdings viele verschiedene Messungen bei unterschiedlichen Frequenzen durchgeführt. Mit einem neuen System ist es möglich, breite Frequenzbereiche zwischen 0,1 mHz und 1 kHz zu messen, wobei das Messprinzip wie folgt ausgestaltet ist. Mit Hilfe eines digitalen Signalprozessors wird ein sinusförmiges Signal von gewünschter Frequenz erzeugt, welches verstärkt und an die Klemmen des Transformators angelegt wird. Die Klemmspannung des Transformators und der dadurch verursachte Strom durch den Transformator werden gemessen. Daraus wird sowohl die Kapazität als auch der Verlustfaktor tan ö des Transformators als Funktion der Frequenz ermittelt. Auf diese Weise wird mit dem FDS-Verfahren der Zustand des Isoliersystems eines Leistungstransformators beurteilt.

All diesen Verfahren ist der Nachteil zu eigen, dass sie in dem relevanten Frequenzbereich von typischerweise 0,1 mHz bis einige hundert Hertz in gewissen Unterbereichen sehr schlechte oder gar keine Ergebnisse liefern bzw. eine sehr lange Messzeit benötigen. Beispielsweise hat das FDS-Verfahren den wesentlichen Nachteil, dass es im Bereich sehr tiefer Frequenzen eine sehr lange Messdauer benötigt. Das PDC-Messverfahren hat für den Zeitbereich den Nachteil, dass für Zeiten unter 1 Sekunde eine Messung praktisch unmöglich ist, da während dieser Zeit die Prüflingskapazität entladen werden muss.

Gegenüber den FDS- bzw. PDC-Verfahren weist das RVM-Verfahren den schwerwiegenden Nachteil auf, dass bei diesem in die Wiederkehrspannungen Material- und Geometrieeigenschaften in schwer überschaubarer Weise eingehen, so dass kein Verfahren bekannt ist, mit dem beide Einflüsse separiert werden könnten.

Es ist daher eine Aufgabe der vorliegenden Erfindung, ein Verfahren und eine Vorrichtung zur Messung einer dielektrischen Antwort eines elektrischen Isoliersystems bereitzustellen, wobei eine schnelle und aussagekräftige Messung über dem gesamten relevanten Frequenzbereich von typischerweise 0,1 mHz bis ca. einige hundert Hertz möglich ist.

Erfindungsgemäß wird die Aufgabe durch ein Verfahren und eine Vorrichtung zur Messung einer dielektrischen Antwort eines elektrischen Isoliersystems durch die Merkmale der unabhängigen Ansprüche 1 bzw. 11 definiert gelöst. Die abhängigen Ansprüche definieren bevorzugte und vorteilhafte Ausführungsbeispiele der vorliegenden Erfindung.

Das erfindungsgemäße Verfahren zur Messung einer dielektrischen Antwort eines elektrischen Isoliersystems besteht darin, dass mit einem Frequenzbereichsverfahren ein erstes Messergebnis und mit einem Zeitbereichverfahren ein zweites Messergebnis bestimmt werden, woraufhin das erste Messergebnis und das zweite Messergebnis zu einem Gesamtmessergebnis als dielektrische Antwort kombiniert werden.

Auf diese Weise ist es möglich, das nachteilige Verhalten eines Verfahrens in bestimmten Bereichen durch die positive Wirkung eines anderen Verfahrens in diesen Bereichen zu kompensieren. Dazu wird die dielektrische Antwort in tiefen Frequenzbereichen (vorzugsweise bis ca. 1 Hz) mit einer PDC-Messung ermittelt und mithilfe von mathematischen Algorithmen in den Frequenzbereich transferiert. Damit ist es nicht mehr notwendig, dass eine FDS-Messung für sehr tiefe Frequenzen ausgeführt werden muss, sondern erst oberhalb ab 1 Hz eingesetzt werden kann. Die Durchführung einer Verlustfaktor- und Kapazitätsmessung (FDS) ist für Frequenzen oberhalb von 1 Hz sehr einfach und kostengünstig. Somit wurde der wesentliche Nachteil des FDS-Verfahrens im niederfrequenten Bereich durch seine sehr lange Messdauer mit dem Einsatz einer PDC-Messung für diesen Frequenzbereich kompensiert.

Der wesentliche Nachteil der PDC-Messung, welche darin besteht, dass bei sehr kurzen Zeiten (unter 1 s nach Kurzschließen des Prüflings) eine empfindliche und sinnvolle Messung nicht möglich ist, wodurch wesentliche Informationen zu Beginn der Messung verloren gehen, wird durch die Verwendung des FDS-Verfahrens, welches im höherfrequenten Bereich auf einfache Weise gute Ergebnisse liefert, kompensiert. Zusammengefasst bedeutet dies, dass die Kombination aus einer PDC-Messung und einer FDS-Messung alle durch die Polarisations- und Depolarisationsvorgänge verursachten Informationen bei kurzer Messzeit bewertet und das gesamte Messsystem vielseitiger und einfacher ausgestaltet werden kann.

In einem bevorzugten Ausführungsbeispiel wird das erste Messergebnis aus dem Frequenzbereichverfahren (FDS) in eine äquivalente Darstellung im Zeitbereich transformiert und mit dem zweiten Messergebnis des Zeitbereichverfahrens (PDC) zu einem im Zeitbereich dargestellten Gesamtmessergebnis kombiniert.

In einem anderen Ausführungsbeispiel wird das zweite Messergebnis aus dem Zeitbereichverfahren (PDC) in eine äquivalente Darstellung im Frequenzbereich transformiert und mit dem ersten Messergebnis des Frequenzbereichverfahrens (FDS) zu einem im Frequenzbereich dargestellten Gesamtmessergebnis kombiniert.

Die Transformationen sowohl vom Zeitbereich in den Frequenzbereich als auch vom Frequenzbereich in den Zeitbereich können mittels mathematischer Algorithmen, wie z. B. Fourier-Transformation bzw. inverse Fourier-Transformation, durchgeführt werden.

In einem weiteren Ausführungsbeispiel erfolgt die Aufteilung der beiden Frequenzbereiche in der Art und Weise, dass das Zeitbereichverfahren auf einen ersten Frequenzbereich und das Frequenzbereichverfahren auf einen zweiten Frequenzbereich angewandt wird, wobei der erste Frequenzbereich eine untere Eckfrequenz von 0 Hz bis einige 0,1 mHz und eine bestimmte obere Eckfrequenz von 1 Hz bis einige Hertz umfasst und der zweite Frequenzbereich alle Frequenzen oberhalb der oberen Eckfrequenz des ersten Frequenzbereichs, welche eine untere Eckfrequenz des zweiten Frequenzbereichs bildet, umfasst.

In einem weiteren Ausführungsbeispiel wird zum Messen des dielektrischen Isoliersystems von einem Verstärker ein AC-Messsignal und ein DC-Messsignal erzeugt, wobei bei dem Messverfahren sowohl sehr kleine DC-Messsignalströme als auch Verlustfaktoren ab etwa 1 Hz gemessen werden können.

Die Diagnose des Zustands des elektrischen Isoliersystems kann einfach durch Auswertung des Gesamtmessergebnisses erfolgen, wobei hierzu eine Kalibration in Zeit- und Frequenzbereich sowie ein Expertensystem zur Anwendung kommen kann.

Die vorliegende Erfindung ist vorzugsweise auf die Messung der dielektrischen Antwort eines elektrischen Isoliersystems eines Leistungstransformators anwendbar, ohne jedoch auf diesen bevorzugten Anwendungsbereich beschränkt zu sein.

Die vorliegende Erfindung wird nachfolgend unter Bezugnahme auf die beigefügte Zeichnung anhand bevorzugter Ausführungsbeispiele näher erläutert.

Fig. 1 zeigt ein Blockschaltbild zum Aufbau eines erfindungsgemäßen Systems zur Messung einer dielektrischen Antwort eines elektrischen Isoliersystems.

Fig. 2a zeigt ein Blockschaltbild zur Kombination zweier Messergebnisse, wobei ein erstes Messergebnis aus dem Frequenzbereichverfahren in den Zeitbereich transformiert wird.

Fig. 2b zeigt ein Blockschaltbild zur erfindungsgemäßen Kombination zweier Messergebnisse, wobei ein zweites Messergebnis aus dem Zeitbereichverfahren in den Frequenzbereich transformiert wird.

Fig. 3 zeigt eine Aufteilung des Frequenzspektrums für das Frequenzbereichverfahren und das Zeitbereichverfahren.

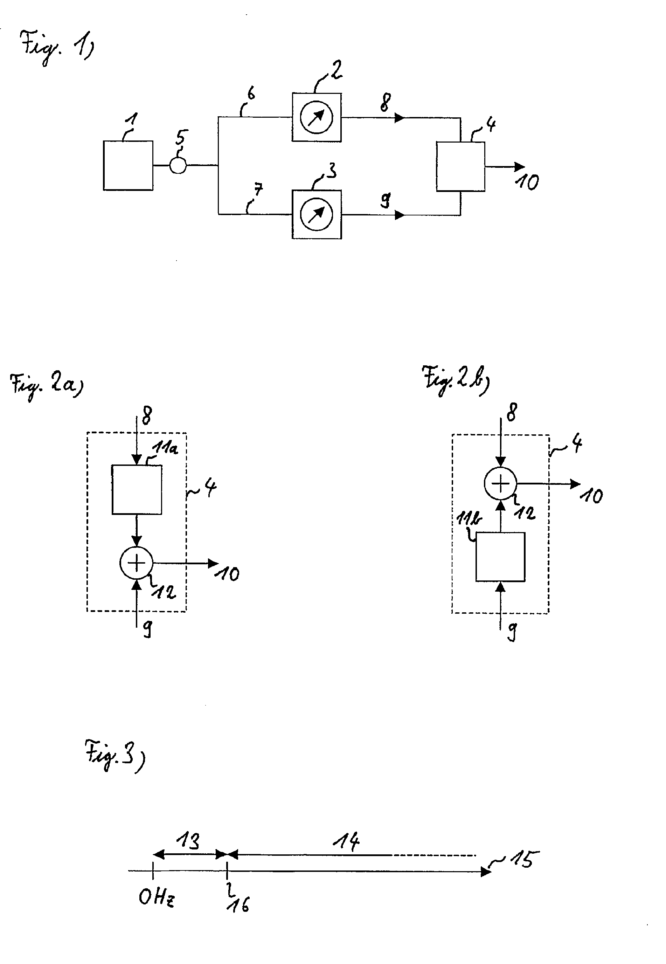

In Fig. 1 ist ein Blockschaltbild eines bevorzugten Ausführungsbeispiels zur Messung einer dielektrischen Antwort eines elektrischen Isoliersystems dargestellt. Ein Frequenzbereichmessmittel 2 ist über eine Verbindung 6 mit einer Klemme 5 eines Transformators 1 verbunden. Ein Zeitbereichmessmittel 3 ist über eine Verbindung 7 mit der Klemme 5 ebenfalls verbunden. Ein mit dem Frequenzbereichmessmittel 2 bestimmtes erstes Messergebnis 8 wird an ein Auswertungsmittel 4 weitergeleitet. Ebenso wird ein mit dem Zeitbereichmessmittel 3 bestimmtes zweites Messergebnis 9 an das Auswertungsmittel 4 geliefert. Das Auswertungsmittel 4 berechnet aus dem ersten Messergebnis 8 und dem zweiten Messergebnis 9 ein Gesamtmessergebnis 10 für die dielektrische Antwort.

Als Frequenzbereichverfahren des Frequenzbereichmessmittels 2 kann beispielsweise ein FDS-Verfahren eingesetzt werden, welches einen Verlustfaktor und eine Kapazität des Isoliermaterials für Frequenzen oberhalb von 1 Hz bestimmt. Für einen Frequenzbereich oberhalb von 1 Hz sind sehr einfach und kostengünstige Messgeräte erhältlich. Beispielsweise werden von einem derartigen Messgerät über einen Verstärker AC-Messsignale und DC-Messsignale erzeugt und an die Transformatorklemme 5 angelegt. Damit werden dann sowohl sehr kleine DC-Messsignalströme als auch Verlustfaktoren ab etwa 1 Hz gemessen, welche Aussagen über den Zustand des Isoliermaterials erlauben.

Das Zeitbereichmessmittel 3 ist beispielsweise als ein PDC-Messmittel ausgestaltet. Nach dem PDC-Verfahren werden vorzugsweise die Polarisations- und Depolarisationsströme für Frequenzen kleiner 1 Hz gemessen. Dazu ist eine Messung für eine Zeitspanne länger als eine Sekunde notwendig. Durch den Einsatz des PDC-Messverfahrens im niederfrequenten Bereich wird die Messzeit gegenüber einer Verwendung des FDS-Verfahrens für das gesamte gewünschte Frequenzspektrum wesentlich verkürzt.

Das Frequenzbereichmessmittel 2 und das Zeitbereichmessmittel 3 können im Prinzip die Funktionen herkömmlicher FDS- bzw. PDC-Messgeräte ausüben, jedoch mit der Besonderheit, dass erfindungsgemäß die unterschiedlichen Messverfahren auf unterschiedliche Frequenzbereiche angewendet werden.

In Fig. 2a ist eine erfindungsgemäße Ausgestaltung des Auswertungsmittels 4 in Form einer Kombination des ersten Messergebnisses 8 aus dem Frequenzbereichverfahren 2 und des zweiten Messergebnisses 9 aus dem Zeitbereichverfahren 3 zu dem Gesamtmessergebnis 10 als dielektrische Antwort dargestellt. Dabei wird das erste Messergebnis 8 mithilfe einer Transformation 11a, beispielsweise einer inversen Fourier-Tranformation, in ein äquivalentes Messergebnis im Zeitbereich transformiert. Dieses äquivalente Messergebnis im Zeitbereich wird mit dem zweiten Messergebnis 9 aus dem Zeitbereichverfahren 3 mittels eines Kombinationsmittels 12 zu dem Gesamtmessergebnis 10 im Zeitbereich kombiniert.

Fig. 2b zeigt eine ähnliche Ausgestaltung des Auswertungsmittels 4 von Fig. 2a. Hierbei wird allerdings das zweite Messergebnis 9 des Zeitbereichverfahrens 3 in ein äquivalentes Messergebnis im Frequenzbereich transformiert 11b, beispielsweise mittels einer Fourier-Transformation. Dieses äquivalente Messergebnis im Frequenzbereich wird mit dem ersten Messergebnis 8 des Frequenzbereichverfahrens 2 mittels des Kombinationsmittels 12 zu dem Gesamtmessergebnis 10 im Frequenzbereich kombiniert.

Der wesentliche Unterschied zwischen einer Ausgestaltung des Auswertungsmittels 4 nach Fig. 2a oder nach Fig. 2b liegt darin, dass zum einen das Gesamtmessergebnis 10 im Zeitbereich und zum anderen das Gesamtmessergebnis 10 im Frequenzbereich vorliegt. Damit kann abhängig von der gewünschten Repräsentation des Gesamtmessergebnisses für die nachfolgenden Weiterverarbeitungsschritte eine Ausgestaltung des Auswertungsmittels 4 entweder gemäß Fig. 2a oder gemäß Fig. 2b gewählt werden. Somit ist eine flexible Verwendbarkeit der Erfindung mit herkömmlichen Messergebnisverarbeitungsmitteln gewährleistet.

Selbstverständlich können auch beide Varianten von Fig. 2a und Fig. 2b in einem Messsystem bzw. Messgerät implementiert werden, um somit zwischen den beiden Varianten bzw. den entsprechenden Messergebnissen umschalten zu können.

In Fig. 3 ist die Aufteilung des Frequenzbandes auf die beiden verschiedenen Messverfahren dargestellt. Dabei wird das Zeitbereichverfahren 3 für einen ersten Frequenzbereich 13, welcher eine untere Eckfrequenz von 0 Hz bis einige 0,1 mHz (vorzugsweise 0,1 mHz) und eine obere Eckfrequenz 16 von z. B. 1 Hz ― mehrere Hertz umfasst, angewandt. Ein zweiter Frequenzbereich 14, beginnend bei der unteren Eckfrequenz 16, welche identisch mit der oberen Eckfrequenz des unteren Frequenzbereichs 13 ist, erstreckt sich bis zu einer oberen Eckfrequenz, welche die Obergrenze des gewünschten Gesamtmessbereichs, zum Beispiel einige hundert Hertz, darstellt. Bevorzugterweise wird zur Messung im unteren Frequenzbereich 13 ein reines PDC-Verfahren verwendet, welches für tiefe Frequenzen besonders hinsichtlich einer kurzen Messdauer als auch einer großen Messgenauigkeit geeignet ist. Für den zweiten Frequenzbereich 14 wird erfindungsgemäß ein FDS-Verfahren verwendet. Hierfür sind insbesondere für Frequenzen oberhalb von 1 Hz Messungen mit einem Verlustfaktor- und Kapazitätsmessgerät sehr einfach und kostengünstig möglich. Daher wird die untere Eckfrequenz 16 des zweiten Frequenzbereichs 14 bevorzugterweise auf etwa 1 Hz gelegt. Allgemein ist vorteilhaft, wenn durch eine relativ tiefe untere Eckfrequenz des ersten Frequenzbereichs und eine möglichst hohe obere Eckfrequenz des ersten Frequenzbereichs ein möglichst breiter Frequenzbereich abgedeckt wird.

Durch das erfindungsgemäße Verfahren und die erfindungsgemäße Vorrichtung kann somit der Zustand eines elektrischen Isoliersystems über eine Kombination zweier Messergebnisse aus herkömmlichen Messverfahren, beispielsweise FDS- und PDC-Verfahren, in kurzer Zeit mit hoher Messgenauigkeit und somit wirtschaftlich ermittelt werden.

## Patentansprüche

1. Verfahren zur Messung einer dielektrischen Antwort eines elektrischen Isoliersystems, wobei mit einem Frequenzbereichverfahren (2) ein erstes Messergebnis (8) und mit einem Zeitbereichverfahren (3) ein zweites Messergebnis (9) des elektrischen Isoliersystems bestimmt wird, woraufhin das erste Messergebnis (8) und das zweite Messergebnis (9) zu einem Gesamtmessergebnis (10) als dielektrische Antwort kombiniert werden.

2. Verfahren nach Anspruch 1,
**dadurch gekennzeichnet,**
**dass** das erste Messergebnis (8) aus dem Frequenzbereichverfahren (2) in eine äquivalente Darstellung im Zeitbereich transformiert (11a) und mit dem zweiten Messergebnis (9) des Zeitbereichverfahrens (3) zu einem im Zeitbereich dargestellten Gesamtmessergebnis (10) kombiniert (12) wird.

3. Verfahren nach Anspruch 1,
**dadurch gekennzeichnet,**
**dass** das zweite Messergebnis (9) aus dem Zeitbereichverfahren (3) in eine äquivalente Darstellung im Frequenzbereich transformiert (11 b) und mit dem ersten Messergebnis (8) des Frequenzbereichverfahrens (2) zu einem im Frequenzbereich dargestellten Gesamtmessergebnis (10) kombiniert (12) wird.

4. Verfahren nach Anspruch 2,
**dadurch gekennzeichnet,**
**dass** das erste Messergebnis (8) aus dem Frequenzbereichverfahren (2) in die äquivalente Darstellung im Zeitbereichbereich transformiert wird.

5. Verfahren nach Anspruch 3,
**dadurch gekennzeichnet,**
**dass** das zweite Messergebnis (9) aus dem Zeitbereichverfahren (3) in die äquivalente Darstellung im Frequenzbereich transformiert wird.

6. Verfahren nach einem der vorhergehenden Ansprüche,
**dadurch gekennzeichnet,**
**dass** als Frequenzbereichverfahren (3) eine Messung eines Verlustfaktors tan δ und einer Kapazität des elektrischen Isoliersystems und als Zeitbereichverfahren eine Polarisations/Depolarisations-Strommessung des elektrischen Isoliersystems verwendet wird.

7. Verfahren nach einem der vorhergehenden Ansprüche,
**dadurch gekennzeichnet,**
**dass** das Zeitbereichverfahren auf einen ersten Frequenzbereich (13) und das Frequenzbereichverfahren auf einen zweiten Frequenzbereich (14) angewandt wird, wobei der erste Frequenzbereich (13) der beiden Frequenzbereiche (13, 14) eine untere Eckfrequenz und eine obere Eckfrequenz (16) umfasst und der zweite Frequenzbereich (14) eine untere Eckfrequenz umfasst, welche der oberen Eckfrequenz (16) des ersten Frequenzbereichs (13) entspricht.

8. Verfahren nach Anspruch 7,
**dadurch gekennzeichnet,**
**dass** die untere Eckfrequenz des ersten Frequenzbereichs (13) 0 Hz bis einige 0,1 mHz und die obere Eckfrequenz des ersten Frequenzbereichs 1 Hz bis einige Hertz beträgt.

9. Verfahren nach einem der vorhergehenden Ansprüche,
**dadurch gekennzeichnet,**
**dass** der Zustand des elektrischen Isoliersystems mit Hilfe einer Kalibration in Zeitbereich und Frequenzbereich diagnostiziert wird.

10. Verfahren nach einem der vorhergehenden Ansprüche,
**dadurch gekennzeichnet,**
**dass** der Zustand des elektrischen Isoliersystems mit Hilfe eines Expertensystems diagnostiziert wird.

11. Vorrichtung zur Messung einer dielektrischen Antwort eines elektrischen Isoliersystems,
- mit einem Frequenzbereichmessmittel (2) zum Bestimmen eines ersten Messergebnisses (8) des elektrischen Isoliersystems im Frequenzbereich,
- mit einem Zeitbereichmessmittel (3) zum Bestimmen eines zweiten Messergebnisses (9) des elektrischen Isoliersystems im Zeitbereich, und
- mit einem Auswertungsmittel (4), welche derart ausgestaltet sind, dass sie das erste Messergebnis (8) und das zweite Messergebnis (9) zu einem Gesamtmessergebnis (10) als dielektrische Antwort kombinieren.

12. Vorrichtung nach Anspruch 11,
**dadurch gekennzeichnet,**
**dass** das Auswertungsmittel (4) ein Transformationsmittel (11a) zur Transformation eines von dem Frequenzbereichmessmittel (2) gelieferten ersten Messergebnisses (8) vom Frequenzbereich in ein äquivalentes Messergebnis im Zeitbereich zur Erzeugung eines Gesamtergebnisses (10) mittels eines Kombinationsmittels (12) beinhaltet, welchem dieses äquivalente Messergebnis im Zeitbereich und das von dem Zeitbereichmessmittel (3) gelieferte zweite Messergebnis (9) zugeführt werden.

13. Vorrichtung nach Anspruch 11,
**dadurch gekennzeichnet,**
**dass** das Auswertungsmittel (4) ein Transformationsmittel (11b) zur Transformation eines von dem Zeitbereichmessmittel (3) gelieferten zweiten Messergebnisses (9) vom Zeitbereich in ein äquivalentes Messergebnis im Frequenzbereich zur Erzeugung eines Gesamtergebnisses (10) mittels eines Kombinationsmittels (12) beinhaltet, welchem dieses äquivalente Messergebnis im Frequenzbereich und das von dem Frequenzbereichmessmittel (2) gelieferte erste Messergebnis (8) zugeführt werden.

14. Vorrichtung nach einem der Ansprüche 11-13,
**dadurch gekennzeichnet,**
**dass** die Vorrichtung zur Diagnose des Zustands des elektrischen Isoliersystems ausgestaltet ist.

15. Vorrichtung nach Anspruch 14,
**dadurch gekennzeichnet,**
**dass** die Vorrichtung zur Diagnose des Zustnds des elektrischen Isoliersystems mit Hilfe einer Kalibration in Zeit- und Frequenzbereich sowie unter Einsatz eines Expertensystems ausgestaltet ist.

16. Vorrichtung nach einem der Ansprüche 11 - 15,
**dadurch gekennzeichnet,**
**dass** die Vorrichtung zur Durchführung des Verfahrens nach einem der Ansprüche 1 - 8 ausgestaltet ist.
